# EUROPÄISCHE PATENTSCHRIFT

(11) **EP 2 701 163 B1**
(45) Veröffentlichungstag und Bekanntmachung des Hinweises auf die Patenterteilung: **25.03.2020**
(21) Anmeldenummer: 12181294.5
(22) Anmeldetag: 22.08.2012
(51) Int. Cl.: H01C 7/12

(54) **Ventilableiter und Kühlkörper dafür**
Valve arrester and cooling body for same
Parafoudre à résistance variable et corps de refroidissement pour celui-ci

(43) Veröffentlichungstag der Anmeldung: 26.02.2014
(73) Patentinhaber: Siemens Aktiengesellschaft, 80333 München (DE)
(72) Erfinder: Pippert, Erhard, 14624 Dallgow-Döberritz OT Seeburg (DE); Sachs, Günter, 91074 Herzogenaurach (DE); Springborn, Dirk, 12203 Berlin (DE); Sulitze, Markus, 14612 Falkensee (DE)

(56) Entgegenhaltungen:
- CA-A1- 1 131 297
- CA-A1- 1 162 978
- CN-U- 201 517 902
- CN-Y- 2 429 917
- DE-A1- 3 417 648
- DE-C- 509 088
- FR-A- 941 621
- FR-A- 1 505 393
- GB-A- 2 322 487
- JP-A- 8 316 007
- JP-A- S62 202 503
- JP-A- 2000 114 007
- JP-U- S5 428 035
- JP-U- S5 878 601
- US-A- 2 870 307
- US-A- 4 335 417

## Beschreibung

Die Erfindung betrifft einen Ventilableiter und einen Kühlkörper für einen Ventilableiter.

Ventilableiter sind Überspannungsableiter zum Begrenzen von Überspannungen. Insbesondere kommen Ventilableiter in geschlossenen Hallen zum Einsatz, in denen sie als gehäuselose Vorrichtungen ausgeführt werden können. Ventilableiter ohne Gehäuse werden beispielsweise zur Überspannungsbegrenzung in so genannten Ventiltürmen von Anlagen zur Hochspannungsgleichstromübertragung eingesetzt. In derartigen Ventiltürmer werden Halbleiterschalter, vor allem Thyristoren, verwendet, die durch hohe Überspannungen beschädigt oder zerstört werden können. Gehäuselose Ventilableiter werden häufig gekühlt, um ihre Belastbarkeit zu erhöhen.

Ein gattungsgemäßer Ventilableiter ist aus der Druckschrift JP S54 28035 U bekannt. Ferner sind Ventilableiter mit Kühlkörpern aus der Druckschrift JP S58 78601 U bekannt.

Der Erfindung liegt die Aufgabe zugrunde, einen Ventilableiter mit einer verbesserten Kühlung anzugeben.

Die Aufgabe wird erfindungsgemäß durch einen Ventilableiter mit den Merkmalen des Anspruchs 1 gelöst.

Vorteilhafte Ausgestaltungen der Erfindung sind Gegenstand der Unteransprüche.

Ein erfindungsgemäßer Ventilableiter weist mehrere Ableitwiderstände, vorzugsweise Metalloxidwiderstände, und mehrere Kühlkörper zur Wärmeabführung aus dem Inneren des Ventilableiters in eine Umgebung des Ventilableiters auf. Jeder Kühlkörper weist einen kreiszylinderartigen Basiskörper auf, dessen Oberfläche eine Grundfläche, eine zu der Grundfläche parallele Deckfläche und eine die Grundfläche und die Deckfläche verbindende Mantelfläche aufweist. Ferner weist jeder Kühlkörper mehrere an dem Basiskörper angeordnete Lamellen auf, wobei jede Lamelle blattartig ausgebildet und an der Mantelfläche des Basiskörpers angeordnet ist. Dabei ist jeder Kühlkörper zwischen zwei Ableitwiderständen angeordnet, so dass die Deckfläche und die Grundfläche jedes Kühlkörpers jeweils mit einem Ableitwiderstand in thermischem Kontakt stehen und eine Oberfläche jeder Lamelle jedes Kühlkörpers eine Außenoberfläche des Ventilableiters bildet.

Durch den Basiskörper kann vorteilhaft Wärme aufgenommen und zu den Lamellen geleitet werden. Die Anordnung der Lamellen an der Mantelfläche, d.h. an der Außenseite des Basiskörpers ermöglicht dabei die Ableitung von Wärme in eine Umgebung des Ventilableiters. Die blattartige Ausgestaltung der Lamellen erzeugt eine gegenüber der Mantelfläche des Kühlkörpers vergrößerte Oberfläche zur Abgabe von Wärme an die Umgebung des Ventilableiters. Die kreiszylindrische Ausgestaltung des Basiskörpers ist der bewährten zylindrischen Bauform von Ventilableitern angepasst und ermöglicht insbesondere eine einfache Stapelung und einen guten thermischen Kontakt von Kühlkörpern und Ableitwiderständen eines Ventilableiters.

Durch die Anordnung der Kühlkörper zwischen je zwei Ableitwiderständen und die Anordnung der Lamellen an der Außenseite des Ventilableiters kann vorteilhaft Wärme von beiden Ableitwiderständen an den Kühlkörper abgegeben, zu den Lamellen geleitet und von diesen an die Luft in der Umgebung des Ventilableiters abgegeben werden. Die verbesserte Kühlwirkung der Kühlkörper verbessert vorteilhaft die Belastbarkeit des Ventilableiters. Mittels eines erfindungsgemäßen Ventilableiters können daher bei gleicher Dauerspannung deutlich niedrigere Schutzpegel erzielt werden, wodurch so genannte Ventillevels, d.h. Ableitwiderstandsschichten, eingespart werden können und die Größe des Ventilableiters reduziert werden kann.

Jede Lamelle ist als ein im Wesentlichen ebener Flachkörper ausgebildet und bildet einen von 90 Grad verschiedenen, schrägen Neigungswinkel mit der Grundfläche des Basiskörpers. Unter einem Flachkörper wird dabei ein dreidimensionaler Körper verstanden, der sich entlang einer zweidimensionalen Erstreckungsfläche erstreckt und dessen maximale Ausdehnung entlang von Flächennormalen der Erstreckungsfläche wesentlich kleiner als eine lineare Ausdehnung der Erstreckungsfläche ist. Als im Wesentlichen eben wird ein Flachkörper bezeichnet, wenn die Erstreckungsfläche eben ist. Unter einem Winkel eines im Wesentlichen ebenen Flachkörpers mit einer Ebene wird ein Winkel zwischen der Erstreckungsfläche des Flachkörpers und der Ebene verstanden.

Diese Ausgestaltung der Erfindung ist insbesondere vorteilhaft, wenn mehrere Kühlkörper eines Ventilableiters übereinander angeordnet sind, so dass ihre Zylinderachsen vertikal, d.h. parallel zur Richtung der Schwerkraft angeordnet sind. Dann sind nämlich die Oberflächen der Lamellen schräg zur Richtung der Schwerkraft angeordnet, so dass die Schwerkraftrichtung nicht in diesen Oberflächen verläuft. Dadurch vergrößern sich die Projektionen dieser Oberflächen auf eine zur Schwerkraftrichtung orthogonale Ebene gegenüber einer Ausrichtung der Lamellen entlang der Schwerkraftrichtung. Die Lamellen eines Kühlkörpers bieten daher erwärmter Luft, die im Schwerefeld aufsteigt, eine größere effektive Fläche zur Wärmeabgabe. Außerdem bewirken sie eine Ablenkung der aufsteigenden Luft, so dass sich ein schraubenförmig aufsteigender Luftstrom ergibt, der einen erhöhten Luftaustausch in der Umgebung des Ventilableiters erzeugt. Sowohl die Vergrößerung der effektiven Wärmeabgabefläche der Lamellen als auch die Erhöhung des Luftaustausches verbessern vorteilhaft die Kühlwirkung der Kühlkörper.

Eine Weitergestaltung dieser ersten Ausgestaltung der Erfindung sieht vor, dass alle Lamellen den gleichen Neigungswinkel mit der Grundfläche des Basiskörpers bilden.

Dadurch sind alle Lamellen in gleichem Maße schräg zur Schwerkraftrichtung ausgerichtet. Dies ermöglicht eine vorhersagbare und planbare Luftströmung in der Umgebung des Ventilableiters und insbesondere eine Verhinderung von Luftstauungen.

Eine alternative zweite bevorzugte Ausgestaltung der Erfindung sieht vor, dass wenigstens eine Lamelle als ein gebogener Flachkörper ausgebildet ist. Unter einem gebogenen Flachkörper wird dabei ein Flachkörper verstanden, dessen Erstreckungsebene gekrümmte geodätische Linien aufweist.

Auch diese Ausgestaltung der Erfindung ermöglicht vorteilhaft eine Verbesserung der Kühlwirkung der Lamellen durch eine Vergrößerung der effektiven Wärmeabgabefläche der Lamellen und eine Erhöhung des Luftaustausches durch eine Beeinflussung des Luftstroms in der Umgebung des Ventilableiters.

Bei beiden Ausgestaltungen der Erfindung steht jede Lamelle vorzugsweise senkrecht von der Mantelfläche des Basiskörpers ab.

Dadurch wird vorteilhaft der Abstand der Lamellenoberflächen von der Mantelfläche des Basiskörpers maximiert und dadurch die Kühlwirkung der Lamellen weiter optimiert.

Weiterhin ist der Kühlkörper vorzugsweise aus einem elektrisch leitfähigen Material, beispielsweise aus Aluminium, gefertigt.

Dadurch kann der Kühlkörper vorteilhaft außer zur Wärmeabführung auch zur Stromführung in dem Ventilableiter verwendet werden.

Vorzugsweise sind die Ableitwiderstände und die Kühlkörper turmartig übereinander gestapelt angeordnet, wobei die Grundflächen aller Kühlkörper senkrecht auf einer Längsachse des Ventilableiters stehen.

Diese Ausgestaltung des Ventilableiters ermöglicht die oben bereits genannte vorteilhafte Verbesserung der Kühlwirkung der Lamellen durch eine Vergrößerung der effektiven Wärmeabgabefläche der Lamellen und eine Erhöhung des Luftaustausches durch eine Lenkung des Luftstroms in der Umgebung des Ventilableiters, wenn die Längsachse des Ventilableiters in Schwerkraftrichtung ausgerichtet wird.

Der Ventilableiter weist Isolierelemente, beispielsweise aus Silikon, auf, die die Ableitwiderstände wenigstens teilweise umgeben und von einer Umgebung des Ventilableiters elektrisch isolieren.

Die Isolierelemente verhindern insbesondere vorteilhaft einen Kriechstrom entlang der Außenseite des Ventilableiters.

In einer weiteren bevorzugten Ausgestaltung des Ventilableiters ist jeder Kühlkörper aus einem elektrisch leitfähigen Material gefertigt und verbindet die Ableitwiderstände, zwischen denen er angeordnet ist, elektrisch miteinander.

Auf diese Weise werden die Kühlkörper vorteilhaft zur elektrischen Verschaltung der Ableitwiderstände genutzt, so dass insbesondere keine zusätzlichen elektrischen Verbindungen der Ableitwiderstände benötigt werden.

Vorzugsweise liegt ferner wenigstens ein Kühlkörper an einem Ableitwiderstand an.

Diese Ausgestaltung der Erfindung ermöglicht einen direkten thermischen und gegebenenfalls auch elektrischen Kontakt zwischen Kühlkörper und Ableitwiderstand und vereinfacht den Aufbau des Ventilableiters.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ausschnittsweise eine perspektivische Schnittdarstellung eines Ventilableiters,
- FIG 2: eine perspektivische Darstellung eines Abschnitts eines Ventilableiters, und
- FIG 3: eine perspektivische Darstellung eines Kühlkörpers für einen Ventilableiter.

Einander entsprechende Teile sind in allen Figuren mit den gleichen Bezugszeichen versehen.

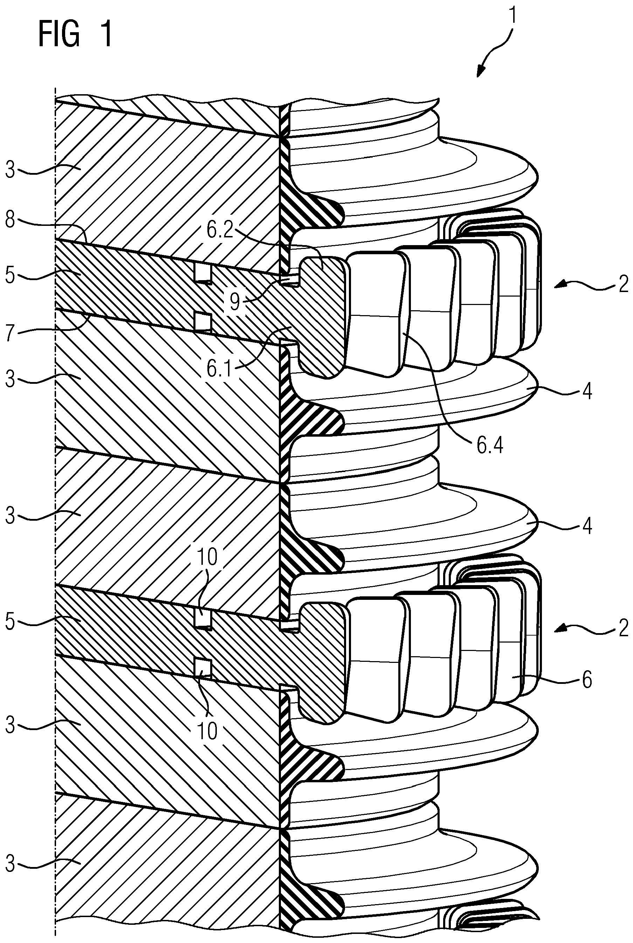

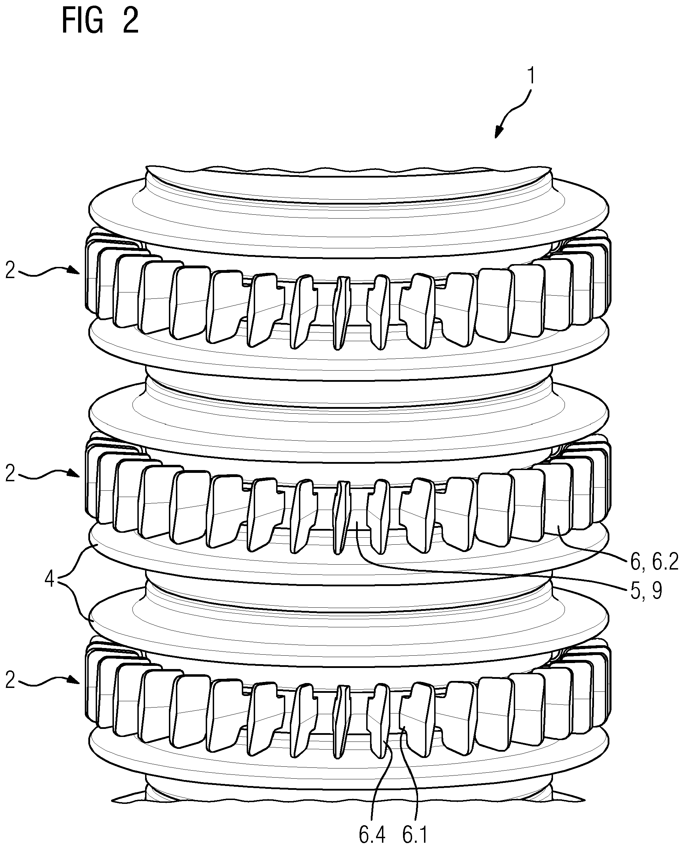

Die Figuren 1 und 2 zeigen ausschnittsweise einen Ventilableiter 1. Dabei zeigt Figur 1 den Ventilableiter 1 in einer perspektivischen Schnittdarstellung und Figur 2 zeigt eine perspektivische Darstellung eines Abschnitts des Ventilableiters 1.

Der Ventilableiter 1 weist mehrere Kühlkörper 2, mehrere Ableitwiderstände 3 und mehrere Isolierelemente 4 auf. Dabei sind die Ableitwiderstände 3 und die Kühlkörper 2 turmartig übereinander gestapelt angeordnet, so dass jeder Kühlkörper 2 zwischen zwei Ableitwiderständen 3 angeordnet ist.

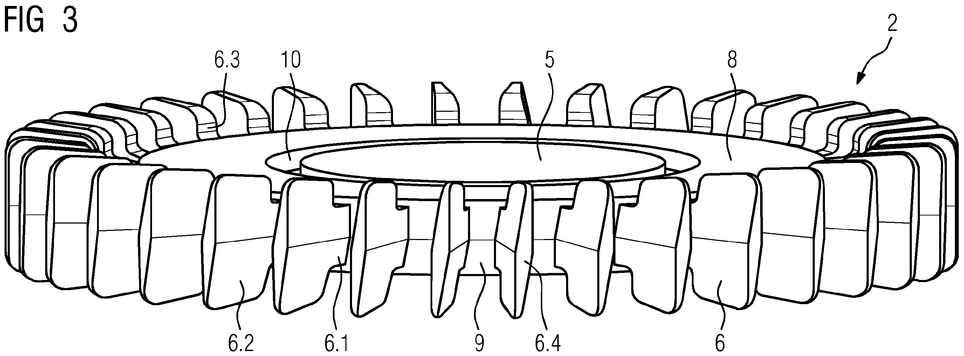

Figur 3 zeigt eine perspektivische Darstellung eines der Kühlkörper 2. Der Kühlkörper 2 ist aus Aluminium gefertigt und einstückig ausgebildet. Er weist einen Basiskörper 5 und mehrere an dem Basiskörper 5 angeordnete blattartige Lamellen 6 auf.

Der Basiskörper 5 ist im Wesentlichen als ein flacher Kreiszylinder ausgebildet, so dass seine Oberfläche eine planare Grundfläche 7, eine zu der Grundfläche 7 parallele planare Deckfläche 8 und eine die Grundfläche 7 und die Deckfläche 8 verbindende, nicht unbedingt planare Mantelfläche 9 aufweist. Optional weisen die Unterseite und die Oberseite des Basiskörpers 5 jeweils eine ringförmige Nut 10 auf, die die Positionierung und Befestigung des Kühlkörpers 2 erleichtert.

Die Lamellen 6 sind an der Mantelfläche 9 des Basiskörpers 5 entlang eines Umfangs der Mantelfläche 9 rippenartig nebeneinander angeordnet und stehen jeweils senkrecht von der Mantelfläche 9 ab. Jede Lamelle 6 ist als im Wesentlichen ebener Flachkörper ausgebildet und weist einen mit der Mantelfläche 9 verbundenen Stegabschnitt 6.1 und einen sich an den Stegabschnitt 6.1 anschließenden Endabschnitt 6.2 auf. Der Endabschnitt 6.2 hat im Wesentlichen die Form eines flachen Hexaeders. Dabei ist eine erste Seitenfläche 6.3 des Hexaeders rautenförmig ausgebildet, der Mantelfläche 9 zugewandt und mit dem Stegabschnitt 6.1 verbunden. Eine ebenfalls rautenförmige zweite Seitenfläche 6.4 verläuft parallel zu der ersten Seitenfläche 6.3 und ist von der Mantelfläche 9 abgewandt.

Die beiden rautenförmigen Seitenflächen 6.3, 6.4 eines Endabschnitts 6.2 weisen jeweils eine längere Diagonale und eine kürzere Diagonale auf, wobei die längeren Diagonalen der beiden rautenförmigen Seitenflächen 6.3, 6.4 zueinander parallel angeordnet sind. Diese längeren Diagonalen der beiden rautenförmigen Seitenflächen 6.3, 6.4 begrenzen eine Querschnittsfläche des Endabschnitts 6.2, die einen von 90 Grad verschiedenen Neigungswinkel mit einer zur Grundfläche des Basiskörpers 5 parallelen Ebene bildet. Der Neigungswinkel ist dabei für alle Lamellen 6 des Kühlkörpers 2 gleich. Dadurch sind alle Lamellen 6 des Kühlkörpers 2 schräg zu einer Zylinderachse des Basiskörpers 5 angeordnet.

Die Ableitwiderstände 3 sind jeweils als kreiszylinderförmige Metalloxidwiderstände ausgebildet. Die Ableitwiderstände 3 und die Basiskörper 5 der Kühlkörper 2 sind koaxial zueinander angeordnet, so dass ihre Zylinderachsen auf einer Gerade liegen, die eine Längsachse des Ventilableiters 1 bildet.

Die Radien der Grund- und Deckflächen der Ableitwiderstände 3 korrespondieren zu den Radien der Grundflächen 7 und Deckflächen 8 der Basiskörper 5 der Kühlkörper 2. Die Grundfläche 7 des Basiskörpers 5 eines Kühlkörpers 2 liegt an der Deckfläche 8 des unter ihm angeordneten Ableitwiderstandes 3 an, die Deckfläche 8 des Basiskörpers 5 eines Kühlkörpers 2 liegt an der Grundfläche 7 des über ihm angeordneten Ableitwiderstandes 3 an. Die Oberflächen der Lamellen 6 bilden Außenoberflächen des Ventilableiters 1.

Die Isolierelemente 4 sind aus Silikon gefertigt. Sie sind jeweils ringförmig ausgebildet und umfassen jeweils die Mantelfläche 9 eines Ableitwiderstandes 3. Eine einem Ableitwiderstand 3 zugewandte Innenoberfläche eines Isolierelementes 4 liegt an der Mantelfläche 9 des Ableitwiderstandes 3 an. Die Außenoberfläche eines Isolierelementes 4 weist eine hutkrempenartig umlaufende Außenwölbung auf.

Der Ventilableiter 1 wird vertikal angeordnet, so dass seine Längsachse in Schwerkraftrichtung verläuft. Wenn im Falle einer Überspannung ein Strom durch den Ventilableiter 1 fließt, erwärmen sich die Ableitwiderstände 3. Die Basiskörper 5 der Kühlkörper 2 nehmen Wärme der Ableitwiderstände 3 auf und leiten sie zu ihren Lamellen 6. Die Lamellen 6 geben Wärme an die Luft in der Umgebung des Ventilableiters 1 ab. Die erwärmte Luft steigt im Schwerefeld auf. Durch die Schrägstellung der Lamellen 6 entsteht entlang der Außenseite des Ventilableiters 1 ein schraubenförmig nach oben verlaufender Luftstrom der erwärmten Luft, der in Figur 2 durch die Richtung von Pfeilen angedeutet ist.

Obwohl die Erfindung im Detail durch ein bevorzugtes Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Beispielsweise können alle oder einige Lamellen 6 statt als im Wesentlichen ebene auch als gebogene Flachkörper ausgebildet sein.

## Patentansprüche

1. Ventilableiter (1) mit mehreren Ableitwiderständen (3) und mit mehreren Kühlkörpern (2) zur Wärmeabführung aus dem Inneren des Ventilableiters (1) in eine Umgebung des Ventilableiters (1), wobei
- jeder Kühlkörper (2) einen kreiszylinderartigen Basiskörper (5), dessen Oberfläche eine Grundfläche (7), eine zu der Grundfläche (7) parallele Deckfläche (8) und eine die Grundfläche (7) und die Deckfläche (8) verbindende Mantelfläche (9) aufweist,
- und jeder Kühlkörper (2) zwischen zwei Ableitwiderständen (3) angeordnet ist,
- so dass die Deckfläche (8) und die Grundfläche (7) jedes Kühlkörpers (2) jeweils mit einem Ableitwiderstand (3) in thermischem Kontakt stehen,
- jeder Kühlkörper (2) mehrere an dem Basiskörper (5) angeordnete Lamellen (6) aufweist,
- jede Lamelle (6) an der Mantelfläche (9) des Basiskörpers (5) angeordnet ist
- und eine Oberfläche jeder Lamelle (6) jedes Kühlkörpers (2) eine Außenoberfläche des Ventilableiters (1) bildet,
**dadurch gekennzeichnet, dass**
jede Lamelle (6) blattartig ausgebildet und einen von 90 Grad verschiedenen, schrägen Neigungswinkel mit einer zur Grundfläche (7) des Basiskörpers (5) parallelen Ebene bildet, und dass
Isolierelemente (4) vorgesehen sind, die die Ableitwiderstände (3) wenigstens teilweise umgeben und von einer Umgebung des Ventilableiters (1) elektrisch isolieren.

2. Ventilableiter (1) nach Anspruch 1,
**dadurch gekennzeichnet, dass** jede Lamelle (6) als ein im Wesentlichen ebener Flachkörper ausgebildet ist.

3. Ventilableiter (1) nach Anspruch 2,
**dadurch gekennzeichnet, dass** alle Lamellen (6) den gleichen Neigungswinkel mit der zur Grundfläche (7) des Basiskörpers (5) parallelen Ebene bilden.

4. Ventilableiter (1) nach Anspruch 1,
**dadurch gekennzeichnet, dass** wenigstens eine Lamelle (6) als ein gebogener Flachkörper ausgebildet ist.

5. Ventilableiter (1) nach einem der vorhergehenden Ansprüche,
**dadurch gekennzeichnet, dass** jede Lamelle (6) senkrecht von der Mantelfläche (9) des Basiskörpers (5) absteht.

6. Ventilableiter (1) nach einem der vorhergehenden Ansprüche,
**dadurch gekennzeichnet, dass** der Kühlkörper (2) aus einem elektrisch leitfähigen Material gefertigt ist.

7. Ventilableiter (1) nach Anspruch 6,
**dadurch gekennzeichnet, dass** der Kühlkörper (2) aus Aluminium gefertigt ist.

8. Ventilableiter (1) nach einem der vorhergehenden Ansprüche,
**dadurch gekennzeichnet, dass** die Ableitwiderstände (3) und die Kühlkörper (2) turmartig übereinander gestapelt angeordnet sind, wobei die Grundflächen (7) aller Kühlkörper (2) senkrecht auf einer Längsachse des Ventilableiters (1) stehen.

9. Ventilableiter (1) nach einem der vorhergehenden Ansprüche,
**dadurch gekennzeichnet, dass** jeder Kühlkörper (2) aus einem elektrisch leitfähigen Material gefertigt ist und die Ableitwiderstände (3), zwischen denen er angeordnet ist, elektrisch miteinander verbindet.

10. Ventilableiter (1) nach einem der vorhergehenden Ansprüche,
**dadurch gekennzeichnet, dass** wenigstens ein Kühlkörper (2) an einem Ableitwiderstand (3) anliegt.

## Claims

1. Valve-type arrester (1) having a plurality of discharging resistors (3) and having a plurality of heat sinks (2) for dissipating heat from the interior of the valve-type arrester (1) in an area surrounding the valve-type arrester (1), wherein
- each heat sink (2) has a circular-cylindrical main body (5), the surface of said main body having a base surface (7), a top surface (8) which is parallel to the base surface (7), and a casing surface (9) which connects the base surface (7) and the top surface (8),
- and each heat sink (2) is arranged between two discharging resistors (3),
- so that the top surface (8) and the base surface (7) of each heat sink (2) are each in thermal contact with a discharging resistor (3),
- each heat sink (2) has a plurality of fins (6) which are arranged on the main body (5),
- each fin (6) is arranged on the casing surface (9) of the main body (5),
- and a surface of each fin (6) of each heat sink (2) forms an outer surface of the valve-type arrester (1),
**characterized in that** each fin (6) is of sheet-like design and forms an oblique inclination angle, which is different from 90 degrees, with a plane which is parallel to the base surface (7) of the main body (5), and **in that** insulating elements (4) are provided which at least partially surround the discharging resistors (3) and electrically insulate said discharging resistors from an area surrounding the valve-type arrester (1).

2. Valve-type arrester (1) according to Claim 1,
**characterized in that** each fin (6) is in the form of a substantially planar flat body.

3. Valve-type arrester (1) according to Claim 2,
**characterized in that** all of the fins (6) form the same inclination angle with the plane which is parallel to the base surface (7) of the main body (5).

4. Valve-type arrester (1) according to Claim 1,
**characterized in that** at least one fin (6) is in the form of a bent flat body.

5. Valve-type arrester (1) according to one of the preceding claims,
**characterized in that** each fin (6) protrudes in a perpendicular manner from the casing surface (9) of the main body (5).

6. Valve-type arrester (1) according to one of the preceding claims,
**characterized in that** the heat sink (2) is produced from an electrically conductive material.

7. Valve-type arrester (1) according to Claim 6,
**characterized in that** the heat sink (2) is produced from aluminum.

8. Valve-type arrester (1) according to one of the preceding claims,
**characterized in that** the discharging resistors (3) and the heat sinks (2) are arranged stacked one above the other in the manner of a tower, wherein the base surfaces (7) of all of the heat sinks (2) are perpendicular to a longitudinal axis of the valve-type arrester (1).

9. Valve-type arrester (1) according to one of the preceding claims,
**characterized in that** each heat sink (2) is produced from an electrically conductive material and electrically connects the discharging resistors (3), between which it is arranged, to one another.

10. Valve-type arrester (1) according to one of the preceding claims,
**characterized in that** at least one heat sink (2) bears against a discharging resistor (3).

## Revendications

1. Parafoudre (1) à résistances variables, comprenant plusieurs résistances (3) et plusieurs refroidisseurs (2) pour évacuer de la chaleur de l'intérieur du parafoudre (1) à résistances variables à une atmosphère environnante du parafoudre (1) à résistances variables, dans lequel
- chaque refroidisseur (2) a un corps (5) de base de type à cylindre de section circulaire, dont la surface a une surface (7) de base, une surface (8) de sommet parallèle à la surface (7) de base et une surface (9) latérale reliant la surface (7) de base et la surface (8) de sommet,
- et chaque refroidisseur (2) est disposé entre deux résistances (3) de parafoudre,
- de sorte que la surface (8) de sommet et la surface (7) de base de chaque refroidisseur (2) est en contact thermique avec, respectivement, une résistance (3) du parafoudre,
- chaque refroidisseur a plusieurs lamelles (6) disposées sur le corps (5) de base,
- chaque lamelle (6) est disposée sur la surface (9) latérale du corps (5) de base,
- et une surface de chaque lamelle (6) de chaque refroidisseur (2) forme une surface extérieure du parafoudre (1) à résistances variables,
**caractérisé en ce que**
chaque lamelle (6) est constituée en étant de type en feuille et fait un angle d'inclinaison différent de 90 degrés avec un plan parallèle à la surface (7) de base du corps (5) de base et **en ce que** il est prévu des éléments (4) isolants, qui entourent, au moins en partie, les résistances (3) du parafoudre et les isolent électriquement d'une atmosphère environnante du parafoudre (1) à résistances variables.

2. Parafoudre (1) à résistances variables suivant la revendication 1,
**caractérisé en ce que** chaque lamelle (6) est constituée d'un corps plat sensiblement plan.

3. Parafoudre (1) à résistances variables suivant la revendication 2,
**caractérisé en ce que** toutes les lamelles (6) font le même angle d'inclinaison avec le plan parallèle à la surface (7) de base du corps (5) de base.

4. Parafoudre (1) à résistances variables suivant la revendication 1,
**caractérisé en ce qu'**au moins une lamelle (6) est constituée sous la forme d'un corps plat incurvé.

5. Parafoudre (1) à résistances variables suivant l'une des revendications précédentes,
**caractérisé en ce que** chaque lamelle (6) fait saillie perpendiculairement de la surface (9) latérale du corps (5) de base.

6. Parafoudre (1) à résistances variables suivant l'une des revendications précédentes,
**caractérisé en ce que** le refroidisseur (2) est en un matériau conducteur de l'électricité.

7. Parafoudre (1) à résistances variables suivant la revendication 6,
**caractérisé en ce que** le refroidisseur (2) est en aluminium.

8. Parafoudre (1) à résistances variables suivant l'une des revendications précédentes,
**caractérisé en ce que** les résistances (3) du parafoudre et les refroidisseurs (2) sont empilés les uns sur les autres à la manière d'une tour, les surfaces (7) de base de tous les refroidisseurs (2) étant perpendiculaires à un axe longitudinal du parafoudre (1) à résistances variables.

9. Parafoudre (1) à résistances variables suivant l'une des revendications précédentes,
**caractérisé en ce que** chaque refroidisseur (2) est en un matériau conducteur de l'électricité et connecte entre elles électriquement les résistances (3) du parafoudre, entre lesquelles il est disposé.

10. Parafoudre (1) à résistances variables suivant l'une des revendications précédentes,
**caractérisé en ce qu'**au moins un refroidisseur (2) s'applique à une résistance (3) du parafoudre.
